# EUROPEAN PATENT SPECIFICATION

(11) **EP 3 397 790 B1**
(45) Date of publication and mention of the grant of the patent: **09.08.2023**
(21) Application number: 16856458.1
(22) Date of filing: 12.12.2016
(51) Int. Cl.: C23C 16/18, C23C 16/34, C23C 16/42, C23C 16/448, C23C 16/455, H01L 21/28, H01L 21/768, H01L 21/285

(54) **COBALT-CONTAINING FILM FORMING COMPOSITIONS, THEIR SYNTHESIS, AND USE IN FILM DEPOSITION**
KOBALTHALTIGE FILMBILDENDE ZUSAMMENSETZUNGEN, DEREN SYNTHESE UND VERWENDUNG IN DER FILMABSCHEIDUNG
COMPOSITIONS FILMOGÈNES CONTENANT DU COBALT, LEUR SYNTHÈSE ET LEUR UTILISATION POUR LE DÉPÔT DE FILM

(30) Priority: 31.12.2015 US 201514986286
(43) Date of publication of application: 07.11.2018
(73) Proprietor: L'Air Liquide, Société Anonyme pour l'Etude et l'Exploitation des Procédés Georges Claude, 75007 Paris (FR)
(72) Inventor: GATINEAU, Satoko, Seoul 06580 (KR); KIMURA, Mikiko, Ibaraki 305-0875 (JP); DUSSARRAT, Christian, Tokyo 120-0223 (JP); GIRARD, Jean-Marc, F-78000 Versailles (FR); BLASCO, Nicolas, F-38180 Echirolles (FR)
(74) Representative: Air Liquide
(86) International application number: PCT/IB2016/001940
(87) International publication number: WO 2017/115138

(56) References cited:
- US-A1- 2014 255 606
- US-A1- 2015 246 941
- US-B1- 6 984 591
- Arunashree Panda ET AL: "Reactions of M{N(SiMe 3 ) 2 } 2 (M 0/ Mn, Fe or Co) with pyridine and 4,4?-bipyridyl: structural and magnetic studies", , 31 December 2003 (2003-12-31), XP055371695, Retrieved from the Internet: URL:http://www.sciencedirect.com/science/a rticle/pii/S0277538702012640/pdfft?md5=6b8 ac8b2f05c14e18cae702e933e842b&pid=1-s2.0-S 0277538702012640-main.pdf [retrieved on 2017-05-11]

## Description

### Technical field

Cobalt-containing film forming compositions, their preparation, and their use for the vapor deposition of films are disclosed. The cobalt-containing film forming compositions comprise silylamide-containing precursors: Co[N(SiMe₃)₂]₂(NMe₂Et) and/or Co[N(SiMe₃)₂]₂(NMeEt₂).

### Background

Chemical Vapor Deposition (CVD) and Atomic Layer Deposition (ALD) have been applied as main deposition techniques for producing thin films for semiconductor devices. These methods enable the achievement of conformal films (metal, oxide, nitride, silicide, etc.) through fine tuning of parameters during the deposition processes. Mainly the film growth is controlled by chemical reactions of metal-containing compounds (precursors) and the development of optimum precursors is essential under prediction of their properties and reaction processes.

Films of transition metals and transition metal silicide, particularly manganese, iron, cobalt, and ruthenium, are becoming important for a variety of electronics and electrochemical applications. For example, cobalt thin films are of interest due to their high magnetic permittivity. There are many reports of using cobalt thin films to form cobalt disilicide (CoSi₂) for Ohmic contacts owing to its low resistivity in front-end-of-the-line processing of semiconductor devices. Cobalt containing thin films were recently studied as Cu/low-k barriers, passivation layers, and capping layers for ultra-large scale integrated devices.

Synthesis of silylamide compounds has been reported (Monatsh. Chem. (1963), 94(6), pp.1007-1012; Polyhedron 22 (2003) pp.67-73, J.C.S.Chem.Comm. (1972) pp.872-873; Inorg. Chem. (1984) 23, 4584-4588; US 6969539B2). Vapor deposition film formation using silylamide compounds has also been reported. (Chem.Vap.Deposition 1995, 1, No. 2, 49-51; R.G.Gordon et al; US 2009/0053426A1 Applied Materials; US 2014/0255606 Applied Materials; US 2014/0255606A1 or US 6984591B1.

US 6969539 to Gordon et al. discloses:

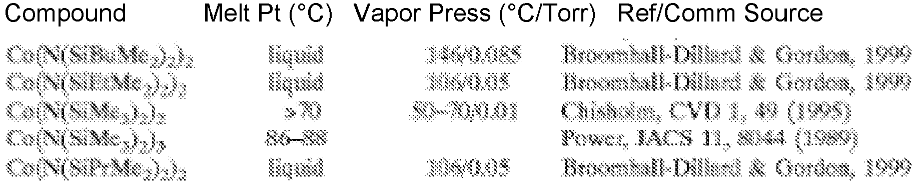

One of ordinary skill in the art will recognize that while the liquid form of the Co-containing precursors is favorable for vapor deposition methods, the disclosed vapor pressures are too low for industrial usage for thin film deposition.

Selecting a Co-containing precursor that is suitably volatile while remaining stable enough for use in vapor phase film deposition is important for commercial implementation and not always easily determined.

### Summary

Disclosed are cobalt-containing film forming compositions comprising a silylamide-containing precursor and a method of depositing a cobalt-containing layer on a substrate as disclosed in claims 1-14.

### Notation and Nomenclature

Certain abbreviations, symbols, and terms are used throughout the following description and claims, and include:
As used herein, the indefinite article "a" or "an" means one or more.

As used herein, the terms "approximately" or "about" mean ±10% of the value stated.

Any and all ranges recited herein are inclusive of their endpoints (i.e., x=1 to 4 includes x=1, x=4, and x=any number in between).

As used herein, the term "alkyl group" refers to saturated functional groups containing exclusively carbon and hydrogen atoms. Further, the term "alkyl group" refers to linear, branched, or cyclic alkyl groups. Examples of linear alkyl groups include without limitation, methyl groups, ethyl groups, propyl groups, butyl groups, etc. Examples of branched alkyls groups include without limitation, t-butyl. Examples of cyclic alkyl groups include without limitation, cyclopropyl groups, cyclopentyl groups, cyclohexyl groups, etc.

As used herein, the term "hydrocarbon" means a functional group containing exclusively hydrogen and carbon atoms. The functional group may be saturated (containing only single bonds) or unsaturated (containing double or triple bonds).

As used herein, the term "heterocycle" means cyclic compounds that have atoms of at least two different elements as members of its ring.

As used herein, the abbreviation "Me" refers to a methyl group; the abbreviation "Et" refers to an ethyl group; the abbreviation "Pr" refers to any propyl group (i.e., n-propyl or isopropyl); the abbreviation "iPr" refers to an isopropyl group; the abbreviation "Bu" refers to any butyl group (n-butyl, iso-butyl, t-butyl, sec-butyl); the abbreviation "tBu" refers to a tert-butyl group; the abbreviation "sBu" refers to a sec-butyl group; the abbreviation "iBu" refers to an iso-butyl group; the abbreviation "Ph" refers to a phenyl group; the abbreviation "py" refers to a pyridine group; the abbreviation "THF" refers to tetrahydrofuran; and the abbreviation "Cp" refers to cyclopentadienyl group.

The standard abbreviations of the elements from the periodic table of elements are used herein. It should be understood that elements may be referred to by these abbreviations (e.g., Co refers to cobalt, Si refers to silicon, C refers to carbon, etc.)

Please note that the films or layers, such as cobalt silicide, are listed throughout the specification and claims without reference to their proper stoichoimetry. The layers may include pure (M) layers, silicide (MₒSiₚ) layers, carbide (MₒCₚ) layers, nitride (MₖNₗ) layers, oxide (MₙOₘ) layers, or mixtures thereof, wherein M is Co; and k, l, m, n, o, and p inclusively range from 1 to 6. For instance, cobalt silicide is CoₖSiₗ, where k and l each range from 0.5 to 5. Similarly, CoₙOₘ may include CoO and Co₃O₄. Any referenced layers may also include a Silicon oxide layer, SiₙOₘ, wherein n ranges from 0.5 to 1.5 and m ranges from 1.5 to 3.5. More preferably, the silicon oxide layer is SiO₂. The silicon oxide layer may be a silicon oxide based dielectric material, such as carbon-doped silicon oxide based low-k dielectric materials such as the Black Diamond II or III material by Applied Materials, Inc. Alternatively, any referenced silicon-containing layer may be pure silicon. Any silicon-containing layers may also include dopants, such as B, C, P, As and/or Ge.

### Brief Description of the Drawings

For a further understanding of the nature and objects of the present invention, reference should be made to the following detailed description, taken in conjunction with the accompanying drawings, in which like elements are given the same or analogous reference numbers and wherein:
**FIG. 1** is a side cross-section view of a Co-containing film forming composition delivery device **1**;
**FIG. 2** is a side cross-section view of a Co-containing film forming composition delivery device **1**;
**FIG. 3** is a side cross-section view of a solid precursor sublimator **100** for subliming solid Co-containing film forming compositions;
**FIG. 4** is a comparative open cup Thermogravimetric Analysis (TGA) graph, under 1010 mbar, demonstrating the percentage of weight loss with increasing temperature of Co[N(SiMe₃)₂]₂(THF), Co[N(SiMe₂Et)₂]₂(THF), Co[N(SiMe₃)₂]₂(py), Co[N(SiMe₃)₂]₂(NMe₂Et), Co[N(SiMe₃)₂]₂(NMeEt₂), Co[N(SiMe₃)₂]₂(NEt₃), Co[N(SiMe₃)₂]₂(Me-pyrrolidine), and Co[N(SiMe₂Et)₂]₂(NMe₂Et);
**FIG. 5** is a comparative open cup TGA graph, under 20 mbar, demonstrating the percentage of weight loss with increasing temperature of Co[N(SiMe₂Et)₂]₂(THF), Co[N(SiMe₃)₂]₂(py), Co[N(SiMe₃)₂]₂(NMeEt₂), Co[N(SiMe₃)₂]₂(NEt₃), Co[N(SiMe₃)₂]₂(Me-pyrrolidine), and Co[N(SiMe₂Et)₂]₂(NMe₂Et);
**FIG. 6** is a comparative TGA graph demonstrating the percentage of weight loss with increasing temperature of Co[N(SiMe₃)₂]₂(py) before and after 1 week of stability testing at 150°C;
**FIG. 7** is a comparative TGA graph demonstrating the percentage of weight loss with increasing temperature of Co[N(SiMe₃)₂]₂(NMe₂Et) before and after 1, 2, and 3 weeks and 1 and 2 months of stability testing at 90°C;
**FIG. 8** is a comparative TGA graph demonstrating the percentage of weight loss with increasing temperature of Co[N(SiMe₃)₂]₂(NMeEt₂) before and after 1, 2, and 3 weeks of stability testing at 80°C;
**FIG. 9** is a comparative TGA graph demonstrating the percentage of weight loss with increasing temperature of Co[N(SiMe₃)₂]₂(1-Me-pyrrolidine) before and after 1 and 2 weeks of stability testing at 110°C; and
**FIG. 10** is a comparative TGA graph demonstrating the percentage of weight loss with increasing temperature of Co[N(SiMe₂Et)₂]₂(NMe₂Et) before and after 1 and 2 weeks of stability testing at 120°C.

### Description of Preferred Embodiments

Disclosed are Co-containing film forming compositions comprising silylamide-containing precursors including {Co[N(SiMe₃)₂]₂}₂; {Co[N(SiMe₂Et)₂]₂}₂; and combinations thereof.

The silylamide-containing precursors may be synthesized by reacting CoX₂, wherein X is Cl, Br, or I, with M(N(SiR¹R²R³)₂), wherein M is Li, Na, or K, in a solvent, such as tetrahydrofuran (THF), ether, pentane, cyclohexane, hexane, heptane, or toluene. The solvent may be removed and the product of Formula I or II isolated from the salt byproduct using filtration and/or sublimation. The L=THF adduct of Formula I may be substituted by adding the protonated form of the desired ligand to an alkane solution, such as pentane, heptane, hexane, or cyclohexane, of the THF-containing precursor and extracting the product. Further details are provided in the examples that follow.

To ensure process reliability, the disclosed Co-containing film forming compositions may be purified by continuous or fractional batch distillation, recrystallization, or sublimation prior to use to a purity ranging from approximately 95% w/w to approximately 100% w/w, preferably ranging from approximately 98% w/w to approximately 100% w/w. The Co-containing film forming composition consists essentially of the silylamide-containing precursor when the purity ranges from approximately 99% w/w to approximately 100% w/w. One of ordinary skill in the art will recognize that the purity may be determined by H NMR or gas or liquid chromatography with mass spectrometry. The Co-containing film forming compositions may contain any of the following impurities: halides, alkali metals, alkyl amines, alkylamino-substituted silanes, pyridine, 1-methylpyrrolidine, pyrrolidine, THF, ether, pentane, cyclohexane, heptane, toluene, halogenated metal compounds. Preferably, the total quantity of these impurities is below 0.1% w/w. The purified composition may be produced by recrystallization, sublimation, distillation, and/or passing the gas or liquid through a suitable adsorbent, such as a 4Å molecular sieve.

The concentration of each solvent, such as THF, ether, pentane, cyclohexane, heptanes, and/or toluene, in the purified Co-containing film forming compositions may range from approximately 0% w/w to approximately 5% w/w, preferably from approximately 0% w/w to approximately 0.1% w/w. Solvents may be used in the Co-containing film forming composition's synthesis. Separation of the solvents from the composition may be difficult if both have similar boiling points. Cooling the mixture may produce solid precursor in liquid solvent, which may be separated by filtration. Vacuum distillation may also be used, provided the composition is not heated above approximately its decomposition point.

The disclosed Co-containing film forming composition contains less than 5% v/v, preferably less than 1% v/v, more preferably less than 0.1% v/v, and even more preferably less than 0.01% v/v of any of its analogs or other reaction products to provide better process repeatability. This may be produced by distillation of the Co-containing film forming composition.

Alternatively, the disclosed Co-containing film forming compositions may comprise between approximately 5% w/w to approximately 50% w/w of one compound with the balance of the composition comprising a second compound, particularly when the mixture provides improved process parameters or isolation of the target compound is too difficult or expensive. For example, the disclosed Co-containing film forming compositions may be 40/60% w/w of Co[N(SiMe₃)₂]₂(NMe₂Et) and Co[N(SiMe₃)₂]₂(NMeEt₂). The mixture may produce a stable, liquid composition suitable for vapor deposition.

The concentration of trace metals and metalloids in the purified Co-containing film forming composition may each range independently from approximately 0 ppbw to approximately 100 ppbw, and more preferably from approximately 0 ppbw to approximately 10 ppbw. These metal or metalloid impurities include, but are not limited to, Aluminum(Al), Arsenic(As), Barium(Ba), Beryllium(Be), Bismuth(Bi), Cadmium(Cd), Calcium(Ca), Chromium(Cr), Copper(Cu), Gallium(Ga), Germanium(Ge), Hafnium(Hf), Zirconium(Zr), Indium(In), Iron(Fe), Lead(Pb), Lithium(Li), Magnesium(Mg), Manganese(Mn), Tungsten(W), Nickel(Ni), Potassium(K), Sodium(Na), Strontium(Sr), Thorium(Th), Tin(Sn), Titanium(Ti), Uranium(U), Vanadium(V) and Zinc(Zn). The concentration of X (where X = Cl, Br) in the purified Co-containing film forming composition may range between approximately 0 ppmw and approximately 100 ppmw and more preferably between approximately 0 ppmw to approximately 10 ppmw.

Care should be taken to prevent exposure of the disclosed Co-containing film forming compositions to water as this may result in decomposition of the silylamine-containing precursors.

Also disclosed are methods of using the disclosed Co-containing film forming compositions for vapor deposition methods. The disclosed methods provide for the use of the Co-containing film forming compositions for deposition of cobalt-containing films. The disclosed methods may be useful in the manufacture of semiconductor, photovoltaic, LCD-TFT, flat panel type devices, refractory materials, or aeronautics.

The disclosed methods for forming a cobalt-containing layer on a substrate include: placing a substrate in a reactor, delivering into the reactor a vapor of the disclosed Co-containing film forming composition, and contacting the vapor with the substrate (and typically directing the vapor to the substrate) to form a cobalt-containing layer on the surface of the substrate.

The methods may include forming a bimetal-containing layer on a substrate using the vapor deposition process and, more specifically, for deposition of CoMNₓ films wherein x is 1-4 and M is Ti, Ta, Mn, Al, lanthanides (such as Er), or combinations thereof. The disclosed methods may be useful in the manufacture of semiconductor, photovoltaic, LCD-TFT, or flat panel type devices. H₂ or a nitrogen source, such as N₂, NH₃, hydrazine, an amine, N radicals thereof, and combinations thereof, but preferably NH₃ or plasma treated N₂, may also be introduced into the reactor.

The disclosed Co-containing film forming compositions may be used to deposit cobalt-containing films using any deposition methods known to those of skill in the art. Examples of suitable deposition methods include chemical vapor deposition (CVD) or atomic layer deposition (ALD). Exemplary CVD methods include thermal CVD, pulsed CVD (PCVD), low pressure CVD (LPCVD), subatmospheric CVD (SACVD) or atmospheric pressure CVD (APCVD), hot-wire CVD (HWCVD, also known as cat-CVD, in which a hot wire serves as an energy source for the deposition process), radicals incorporated CVD, plasma enhanced CVD (PECVD) including but not limited to flowable PECVD, and combinations thereof. Exemplary ALD methods include thermal ALD, plasma enhanced ALD (PEALD), spatial isolation ALD, hot-wire ALD (HWALD), radicals incorporated ALD, and combinations thereof. Super critical fluid deposition may also be used. The deposition method is preferably ALD, PE-ALD, or spatial ALD in order to provide suitable step coverage and film thickness control.

The vapor of the Co-containing film forming composition is generated and then introduced into a reaction chamber containing a substrate. The temperature and the pressure in the reaction chamber and the temperature of the substrate are held at conditions suitable for vapor deposition of at least part of the silylamine-containing precursor onto the substrate. In other words, after introduction of the vaporized composition into the reaction chamber, conditions within the reaction chamber are adjusted such that at least part of the precursor is deposited onto the substrate to form the Co-containing layer. One of ordinary skill in the art will recognize that "at least part of the precursor is deposited" means that some or all of the precursor reacts with or adheres to the substrate. Herein, a reactant may also be used to help in formation of the Co-containing layer.

The reaction chamber may be any enclosure or chamber of a device in which deposition methods take place, such as, without limitation, a parallel-plate type reactor, a cold-wall type reactor, a hot-wall type reactor, a single-wafer reactor, a multi-wafer reactor, or other such types of deposition systems. All of these exemplary reaction chambers are capable of serving as an ALD or CVD reaction chamber. The reaction chamber may be maintained at a pressure ranging from about 0.5mTorr to about 20Torr for all ALD and subatmospheric CVD. Subatmospheric CVD and atmospheric CVD pressures may range up to 760Torr (atmosphere). In addition, the temperature within the reaction chamber may range from about 20°C to about 600°C. One of ordinary skill in the art will recognize that the temperature may be optimized through mere experimentation to achieve the desired result.

The temperature of the reactor may be controlled by either controlling the temperature of the substrate holder or controlling the temperature of the reactor wall. Devices used to heat the substrate are known in the art. The reactor wall is heated to a sufficient temperature to obtain the desired film at a sufficient growth rate and with desired physical state and composition. A non-limiting exemplary temperature range to which the reactor wall may be heated includes from approximately 20°C to approximately 600°C. When a plasma deposition process is utilized, the deposition temperature may range from approximately 20°C to approximately 550°C. Alternatively, when a thermal process is performed, the deposition temperature may range from approximately 300°C to approximately 600°C.

Alternatively, the substrate may be heated to a sufficient temperature to obtain the desired cobalt-containing film at a sufficient growth rate and with desired physical state and composition. A non-limiting exemplary temperature range to which the substrate may be heated includes from 150°C to 600°C. Preferably, the temperature of the substrate remains less than or equal to 500°C.

The reactor contains one or more substrates onto which the films will be deposited. A substrate is generally defined as the material on which a process is conducted. The substrates may be any suitable substrate used in semiconductor, photovoltaic, flat panel, or LCD-TFT device manufacturing. Examples of suitable substrates include wafers, such as silicon, silica, glass, or GaAs wafers. The wafer may have one or more layers of differing materials deposited on it from a previous manufacturing step. For example, the wafers may include silicon layers (crystalline, amorphous, porous, *etc.*), silicon oxide layers, silicon nitride layers, silicon oxy nitride layers, carbon doped silicon oxide (SiCOH) layers, or combinations thereof. Additionally, the wafers may include copper layers or noble metal layers (*e.g*. platinum, palladium, rhodium, or gold). The layers may include oxides which are used as dielectric materials in MIM, DRAM, or FeRam technologies (*e.g*., ZrO₂ based materials, HfO₂ based materials, TiO₂ based materials, rare earth oxide based materials, ternary oxide based materials such as strontium ruthenium oxide [SRO], *etc.*) or from nitride-based films (*e.g*., TaN) that are used as an oxygen barrier between copper and the low-k layer. The wafers may include barrier layers, such as manganese, manganese oxide, *etc.* Plastic layers, such as poly(3,4-ethylenedioxythiophene)poly (styrenesulfonate) [PEDOT:PSS] may also be used. The layers may be planar or patterned. For example, the layer may be a patterned photoresist film made of hydrogenated carbon, for example CHₓ, wherein x is greater than zero.

The disclosed processes may deposit the cobalt-containing layer directly on the wafer or directly on one or more than one (when patterned layers form the substrate) of the layers on top of the wafer. The substrate may be patterned to include vias or trenches having high aspect ratios. For example, a conformal Co-containing film, such as CoSi₂, may be deposited using any ALD technique on a through silicon via (TSV) having an aspect ratio ranging from approximately 20:1 to approximately 100:1. Furthermore, one of ordinary skill in the art will recognize that the terms "film" or "layer" used herein refer to a thickness of some material laid on or spread over a surface and that the surface may be a trench or a line. Throughout the specification and claims, the wafer and any associated layers thereon are referred to as substrates. In many instances though, the preferred substrate utilized may be selected from carbon-doped SiO₂, TaN, Ta, TiN, Ru, and Si type substrates, such as polysilicon or crystalline silicon substrates.

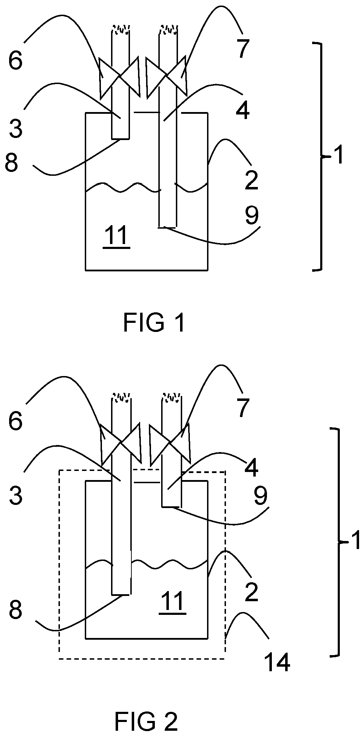

The Co-containing film forming compositions may be delivered to the reactor or vapor deposition chamber by the Co-containing film forming composition delivery devices of **FIGS 1-3****,** which show three exemplary embodiments of Co-containing film forming composition delivery devices.

**FIG 1** is a side view of a Co-containing film forming composition reactant delivery device **1.** In **FIG 1****,** the disclosed Co-containing film forming compositions **11** are contained within a container **2** having two conduits, an inlet conduit **3** and an outlet conduit **4.** One of ordinary skill in the reactant art will recognize that the container **2**, inlet conduit **3**, and outlet conduit **4** are manufactured to prevent the escape of the gaseous form of the Co-containing film forming composition **11**, even at elevated temperature and pressure.

The outlet conduit **4** of the delivery device **1** fluidly connects to the reactor (not shown) or other components between the delivery device and the reactor, such as a gas cabinet, via valve **7**. Preferably, the container **2**, inlet conduit **3**, valve **6**, outlet conduit **4**, and valve **7** are made of 316L EP or 304 stainless steel. However, one of ordinary skill in the art will recognize that other non-reactive materials may also be used in the teachings herein.

In **FIG 1**, the end **8** of inlet conduit **3** is located above the surface of the Co-containing film forming composition **11**, whereas the end **9** of the outlet conduit **4** is located below the surface of the Co-containing film forming composition **11**. The Co-containing film forming composition **11** is preferably in liquid form. An inert gas, including but not limited to nitrogen, argon, helium, and mixtures thereof, may be introduced into the inlet conduit **3**. The inert gas pressurizes the delivery device **2** so that the liquid Co-containing film forming composition **11** is forced through the outlet conduit **4** and to the reactor (not shown). The reactor may include a vaporizer which transforms the liquid Co-containing film forming composition **11** into a vapor, with or without the use of a carrier gas such as helium, argon, nitrogen or mixtures thereof, in order to deliver the vapor to the substrate on which the film will be formed. Alternatively, the liquid Co-containing film forming composition **10** may be delivered directly to the wafer surface as a jet or aerosol.

**FIG 2** is a side view of a Co-containing film forming composition delivery device 1. In **FIG 2**, the end **8** of inlet conduit **3** is located below the surface of the Co-containing film forming composition **11**, whereas the end **9** of the outlet conduit **4** is located above the surface of the Co-containing film forming composition **11**. **FIG 2** also includes an optional heating element **14**, which may increase the temperature of the Co-containing film forming composition **11**. The Co-containing film forming composition **11** may be in solid or liquid form. An inert gas, including but not limited to nitrogen, argon, helium, and mixtures thereof, is introduced into the inlet conduit **3**. The inert gas bubbles through the Co-containing film forming composition **11** and carries a mixture of the inert gas and vaporized Co-containing film forming composition **11** to the outlet conduit **4** and on to the reactor. Bubbling with the carrier gas may also remove any dissolved oxygen present in the Co-containing film forming composition.

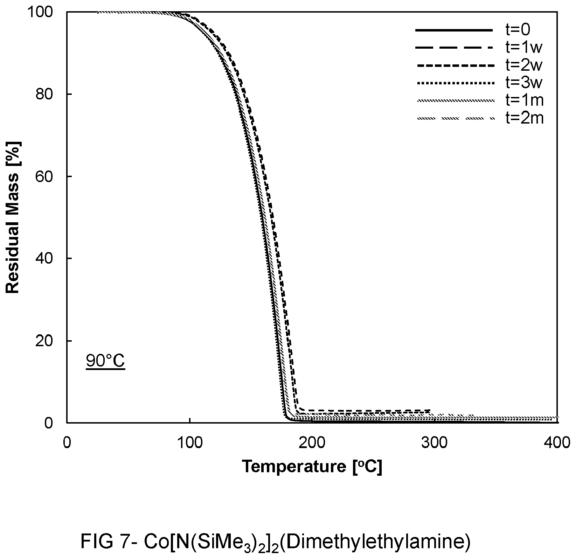

**FIGS 1 and 2** include valves **6** and **7**. One of ordinary skill in the art will recognize that valves **6** and **7** may be placed in an open or closed position to allow flow through conduits **3** and **4**, respectively. Either delivery device **1** in **FIGS 1 and 2**, or a simpler delivery device having a single conduit terminating above the surface of any solid or liquid present, may be used if the Co-containing film forming composition **11** is in vapor form or if sufficient vapor pressure is present above the solid/liquid phase. In this case, the Co-containing film forming composition **11** is delivered in vapor form through the conduit **3** or **4** simply by opening the valve **6** in **FIG 1** or **7** in **FIG 2**. The delivery device **1** may be maintained at a suitable temperature to provide sufficient vapor pressure for the Co-containing film forming composition **11** to be delivered in vapor form, for example by the use of an optional heating element **14**.

While **FIGS 1 and 2** disclose a Co-containing film forming composition delivery device **1**, one of ordinary skill in the art will recognize that the inlet conduit **3** and outlet conduit **4** may also both be located above or below the surface of the Co-containing film forming composition **11** without departing from the disclosure herein. Furthermore, inlet conduit **3** may be a filling port.

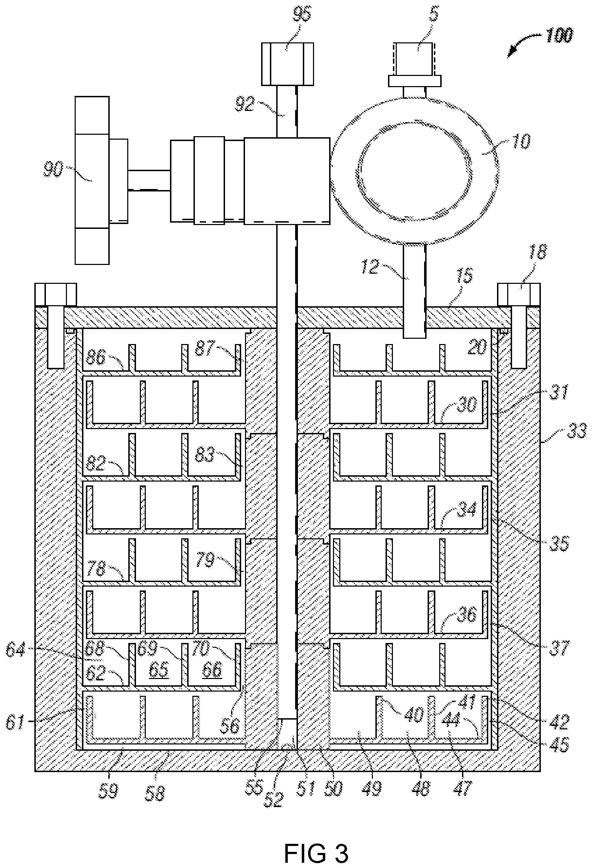

The vapors of solid forms of the Co-containing film forming compositions may be delivered to the reactor using a sublimator. **FIG 3** shows an exemplary sublimator **100**. The sublimator **100** comprises a container **33**.
Container **33** may be a cylindrical container, or alternatively, may be any shape, without limitation. The container **33** is constructed of materials such as stainless steel, nickel and its alloys, quartz, glass, and other chemically compatible materials, without limitation. In certain instances, the container **33** is constructed of another metal or metal alloy, without limitation. In certain instances, the container **33** has an internal diameter from about 8 centimeters to about 55 centimeters and, alternatively, an internal diameter from about 8 centimeters to about 30 centimeters. As understood by one skilled in the art, alternate configurations may have different dimensions.

Container **33** comprises a sealable top **15**, sealing member **18**, and gasket **20**. Sealable top **15** is configured to seal container **33** from the outer environment. Sealable top **15** is configured to allow access to the container **33**. Additionally, sealable top **15** is configured for passage of conduits into container **33**. Alternatively, sealable top **15** is configured to permit fluid flow into container **33**. Sealable top **15** is configured to receive and pass through a conduit comprising a dip tube **92** to remain in fluid contact with container **33**. Dip tube **92** having a control valve **90** and a fitting **95** is configured for flowing carrier gas into container **33**. In certain instances, dip tube **92** extends down the center axis of container **33**. Further, sealable top **15** is configured to receive and pass through a conduit comprising outlet tube **12**. The carrier gas and vapor of the Co-containing film forming composition is removed from container **33** through the outlet tube **12**. Outlet tube **12** comprises a control valve **10** and fitting **5**. In certain instances, outlet tube **12** is fluidly coupled to a gas delivery manifold, for conducting carrier gas from the sublimator **100** to the reactor.

Container **33** and sealable top **15** are sealed by at least two sealing members **18**; alternatively, by at least about four sealing members. In certain instance, sealable top **15** is sealed to container **33** by at least about eight sealing members **18**. As understood by one skilled in the art, sealing member **18** releasably couples sealable top **15** to container **33**, and forms a gas resistant seal with gasket **20**. Sealing member **18** may comprise any suitable means known to one skilled in the art for sealing container **33**. In certain instances, sealing member **18** comprises a thumbscrew.

As illustrated in **FIG 3**, container **33** further comprises at least one disk disposed therein. The disk comprises a shelf, or horizontal support, for solid material. An interior disk **30** may be disposed annularly within the container **33**, such that the disk **30** includes an outer diameter or circumference that is less than the inner diameter or circumference of the container **33**, forming an opening **31**. An exterior disk **86** is disposed circumferentially within the container **33**, such that the disk **86** comprises an outer diameter or circumference that is the same, about the same, or generally coincides with the inner diameter of the container **33**. Exterior disk **86** forms an opening **87** disposed at the center of the disk. A plurality of disks is disposed within container **33**. The disks are stacked in an alternating fashion, wherein interior disks **30, 34, 36, 44** are vertically stacked within the container with alternating exterior disks **62, 78, 82, 86.** Interior disks **30, 34, 36, 44** may extend annularly outward, and exterior disks **62, 78, 82, 86** extend annularly toward the center of container **33.** As illustrated in **FIG 3**, interior disks **30, 34, 36, 44** are not in physical contact with exterior disks **62, 78, 82, 86.**

The assembled sublimator **100** comprises interior disks **30, 34, 36, 44** comprising aligned and coupled support legs **50,** interior passage **51,** concentric walls **40, 41, 42,** and concentric slots **47, 48, 49.** The interior disks **30, 34, 36, 44** are vertically stacked, and annularly oriented about the dip tube **92**. Additionally, the sublimator comprises exterior disks **62, 78, 82, 86.** As illustrated in **FIG 3**, the exterior disks **62, 78, 82, 86** should be tightly fit into the container **33** for a good contact for conducting heat from the container **33** to the disks **62, 78, 82, 86.** Preferably, the exterior disks **62, 78, 82, 86** are coupled to, or in physical contact with, the inner wall of the container **33.**

As illustrated, exterior disks **62, 78, 82, 86** and interior disks **30, 34, 36, 44** are stacked inside the container **33.** When assembled in container **33** to form sublimator **100,** the interior disks **30, 34, 36, 44** form outer gas passages **31, 35, 37, 45** between the assembled exterior disks **62, 78, 82, 86.** Further, exterior disks **62, 78, 82, 86** form inner gas passages **56, 79, 83, 87** with the support legs of the interior disks **30, 34, 36, 44.** The walls **40, 41, 42** of interior disks **30, 34, 36, 44** form the grooved slots for holding solid precursors. Exterior disks **62, 78, 82, 86** comprise walls **68, 69, 70** for holding solid precursors. During assembly, the solid precursors are loaded into the annular slots **47, 48, 49** of interior disks **30, 34, 36, 44** and annular slots **64, 65, 66** of exterior disks **62, 78, 82, 86.**

Solid powders and/or granular particles of sizes less than about 1 centimeter, alternatively less than about 0.5 centimeter, and alternatively less than about 0.1 centimeter are loaded into the annular slots **47, 48, 49** of interior disks **30, 34, 36, 44** and annular slots **64, 65, 66** of exterior disks **62, 78, 82, 86.** The solid precursors are loaded into the annular slots of each disk by any method suitable for uniform distribution of solid in the annular slots. Suitable methods include direct pour, using a scoop, using a funnel, automated measured delivery, and pressurized delivery, without limitation. Depending on the chemical properties of the solid precursor materials, loading may be conducted in a sealed environment. Additionally, inert gas atmosphere and/or pressurization in a sealed box may be implemented for those toxic, volatile, oxidizable, and/or air sensitive solids. Each disk could be loaded after setting the disk in the container **33.** A more preferred procedure is to load the solid prior to setting the disk into container **33.** The total weight of solid precursor loaded into the sublimator may be recorded by weighing the sublimator before and after loading process. Further, consumed solid precursor may be calculated by weighing the sublimator after the vaporization and deposition process.

Dip tube **92**, having the control valve **90** and the fitting **95,** is positioned in the center passage **51** of the aligned and coupled support legs of the interior disks **30, 34, 36, 44.** Thus, dip tube **92** passes through interior passage **51** vertically toward bottom **58** of container **33.** The dip tube end **55** is disposed proximal to the bottom **58** of container at/or above the gas windows **52.** Gas windows **52** are disposed in bottom interior disk **44.** The gas windows **52** are configured to allow carrier gas flow out of the dip tube **92.** In the assembled sublimator **100,** a gas passageway **59** is formed by the bottom surface **58** of the container **33,** and the bottom interior disk **44.** In certain instances, gas passageway **59** is configured to heat carrier gas.

In operation, the carrier gas is preheated prior to introduction into the container **33** via dip tube **92.** Alternatively, the carrier gas can be heated while it flows through the gas passageway **59** by the bottom surface **58.** Bottom surface **58** is thermally coupled and/or heated by an external heater consistently with the teachings herein. The carrier gas then passes through the gas passageway **45** that is formed by the outer wall **42** of the interior disk **44** and the outside wall **61** of the exterior disk **62.** The gas passageway **45** leads to the top of the interior disk **44.** The carrier gas continuously flows over the top of the solid precursors loaded into the annular slots **47, 48,** and **49.** Sublimed solid vapor from annular slots **47, 48, 49** is mixed with carrier gas and is flowed vertically upward through container **33.**

While **FIG 3** discloses a sublimator capable of delivering the vapor of any solid Co-containing film forming composition to the reactor, one of ordinary skill in the art will recognize that other sublimator designs may also be suitable, without departing from the teachings herein. Finally, one of ordinary skill in the art will recognize that the disclosed Co-containing film forming composition may be delivered to semiconductor processing tools using other delivery devices, such as the ampoules disclosed in WO 2006/059187 to Jurcik et al., without departing from the teachings herein.

If necessary, the Co-containing film forming composition devices of **FIGS 1-3** may be heated to a temperature that permits the Co-containing film forming composition to be in its liquid phase and to have a sufficient vapor pressure. The delivery device may be maintained at temperatures in the range of, for example, 0-150°C. Those skilled in the art recognize that the temperature of the delivery device may be adjusted in a known manner to control the amount of Co-containing film forming composition vaporized.

In addition to the disclosed precursor, a reactant may also be introduced into the reactor. The reactant may contain oxygen, such as one of O₂, O₃, H₂O, H₂O₂; oxygen containing radicals, such as O· or OH·, NO, NO₂; carboxylic acids such as formic acid, acetic acid, propionic acid, radical species of NO, NO₂, or the carboxylic acids; para-formaldehyde; and mixtures thereof. Preferably, the oxygen-containing reactant is selected from the group consisting of O₂, O₃, H₂O, H₂O₂, oxygen containing radicals thereof such as O· or OH·, and mixtures thereof. Preferably, when an ALD process is performed, the reactant is plasma treated oxygen, ozone, or combinations thereof. When an oxygen-containing reactant is used, the resulting cobalt containing film will also contain oxygen.

Alternatively, the reactant may be one of H₂, NH₃, (SiH₃)₃N, hydridosilanes (for example, SiH₄, Si₂H₆, Si₃H₈, Si₄H₁₀, Si₅H₁₀, Si₆H₁₂), chlorosilanes and chloropolysilanes (for example, SiHCl₃, SiH₂Cl₂, SIH₃Cl, Si₂Cl₆, Si₂HCl₅, Si₃Cl₈), alkylsilanes (for example, (CH₃)₂SiH₂, (C₂H₅)₂SiH₂, (CH₃)SiH₃, (C₂H₅)SiH₃), hydrazines (for example, N₂H₄, MeHNNH₂, MeHNNHMe), organic amines (for example, N(CH₃)H₂, N(C₂H₅)H₂, N(CH₃)₂H, N(C₂H₅)₂H, N(CH₃)₃, N(C₂H₅)₃, (SiMe₃)₂NH), pyrazoline, pyridine, B-containing molecules (for example, B₂H₆, 9-borabicyclo[3,3,1]none, trimethylboron, triethylboron, borazine), alkyl metals (such as trimethylaluminum, triethylaluminum, dimethylzinc, diethylzinc), alcohols (for example ethanol or methanol), radical species thereof, and mixtures thereof. Preferably, the reactant is H₂, NH₃, SiH₄, Si₂H₆, Si₃H₈, SiH₂Me₂, SiH₂Et₂, N(SiH₃)₃, ethanol, hydrogen radicals thereof, or mixtures thereof. Preferably, the reactant is SiHCl₃, Si₂Cl₆, Si₂HCl₅, Si₂H₂Cl₄, and cyclo-Si₆H₆Cl₆. When these reactants are used, the resulting Co-containing film may be pure Co.

The reactant may be treated by plasma, in order to decompose the reactant into its radical form. N₂ may also be utilized as a reactant when treated with plasma. For instance, the plasma may be generated with a power ranging from about 50W to about 500W, preferably from about 100W to about 200W. The plasma may be generated or present within the reactor itself. Alternatively, the plasma may generally be at a location removed from the reactor, for instance, in a remotely located plasma system. One of skill in the art will recognize methods and apparatus suitable for such plasma treatment.

The disclosed Co-containing film forming composition may also be used with a halosilane or polyhalodisilane, such as hexachlorodisilane, pentachlorodisilane, or tetrachlorodisilane, and one or more reactants to form CoSi, CoSiCN, or CoSiCOH films.

When the desired Co-containing film also contains another element, such as, for example and without limitation, Ti, Mn, Ta, Hf, Nb, Mg, Al, Sr, Y, Ba, Ca, As, Sb, Bi, Sn, Pb, lanthanides (such as Er), or combinations thereof, the reactants may include a another precursor which is selected from, but not limited to, alkyls, such as Ln(RCp)₃, alkylamines, such as Ti(NEt₂)₄, or any combination thereof.

The Co-containing film forming composition and one or more reactants may be introduced into the reaction chamber simultaneously (*e.g*., CVD), sequentially (*e.g*., ALD), or in other combinations. For example, the Co-containing film forming composition may be introduced in one pulse and two additional reactants may be introduced together in a separate pulse (*e.g*., modified ALD). Alternatively, the reaction chamber may already contain the reactant prior to introduction of the Co-containing film forming composition. The reactant may be passed through a plasma system localized or remotely from the reaction chamber, and decomposed to radicals. Alternatively, the Co-containing film forming composition may be introduced to the reaction chamber continuously while other reactants are introduced by pulse (*e.g*., pulsed-CVD). In each example, a pulse may be followed by a purge or evacuation step to remove excess amounts of the component introduced. In each example, the pulse may last for a time period ranging from about 0.01s to about 10s, alternatively from about 0.3s to about 3s, alternatively from about 0.5s to about 2s. In another alternative, the Co-containing film forming composition and one or more reactants may be simultaneously sprayed from a shower head under which a susceptor holding several wafers is spun (e.g., spatial ALD).

In one non-limiting exemplary ALD type process, the vapor phase of a Co-containing film forming composition is introduced into the reaction chamber, where at least part of the silylamine-containing precursor reacts with a suitable substrate, such as Si, SiO₂, AlO₃, *etc.,* to form an adsorbed cobalt layer. Excess composition may then be removed from the reaction chamber by purging and/or evacuating the reaction chamber. An oxygen source is introduced into the reaction chamber where it reacts with the absorbed cobalt layer in a self-limiting manner. Any excess oxygen source is removed from the reaction chamber by purging and/or evacuating the reaction chamber. If the desired film is a cobalt oxide film, this two-step process may provide the desired film thickness or may be repeated until a film having the necessary thickness has been obtained.

Alternatively, if the desired film contains a second element (*i.e*., CoMNₓ, wherein x may be 1-4 and M is Ti, Ta, Hf, Nb, Mg, Al, Sr, Y, Ba, Ca, As, Sb, Bi, Sn, Pb, lanthanides (such as Er), or combinations thereof), the two-step process above may be followed by introduction of a vapor of a second precursor into the reaction chamber. The second precursor will be selected based on the nature of the film being deposited. After introduction into the reaction chamber, the second precursor is contacted with the substrate. Any excess second precursor is removed from the reaction chamber by purging and/or evacuating the reaction chamber. Once again, an N source may be introduced into the reaction chamber to react with the second precursor. Excess N source is removed from the reaction chamber by purging and/or evacuating the reaction chamber. If a desired film thickness has been achieved, the process may be terminated. However, if a thicker film is desired, the entire four-step process may be repeated. By alternating the provision of the Co-containing film forming composition, second precursor, and N source, a film of desired composition and thickness can be deposited.

Additionally, by varying the number of pulses, films having a desired stoichiometric M:Co ratio may be obtained. For example, a CoMN film may be obtained by having one pulse of the Co-containing film forming composition and one pulses of the second precursor, with each pulse being followed by pulses of the NH₃ source. However, one of ordinary skill in the art will recognize that the number of pulses required to obtain the desired film may not be identical to the stoichiometric ratio of the resulting film.

The cobalt-containing films resulting from the processes discussed above may include Co, CoSi₂, CoO₂, CoN, CoMN, CoC, CoON, CoCN, CoCON, or MCoOₓ , wherein M is an element such as Hf, Zr, Ti, Nb, Ta, or Ge, and x may be from 0-4, depending on the oxidation state of M. One of ordinary skill in the art will recognize that by judicial selection of the appropriate Co-containing film forming composition and reactants, the desired film composition may be obtained.

Upon obtaining a desired film thickness, the film may be subject to further processing, such as thermal annealing, furnace-annealing, rapid thermal annealing, UV or e-beam curing, and/or plasma gas exposure. Those skilled in the art recognize the systems and methods utilized to perform these additional processing steps. For example, the cobalt-containing film may be exposed to a temperature ranging from approximately 200°C and approximately 1000°C for a time ranging from approximately 0.1 second to approximately 7200 seconds under an inert atmosphere, a H-containing atmosphere, a N-containing atmosphere, an O-containing atmosphere, or combinations thereof. Most preferably, the temperature is 600°C for less than 3600 seconds under an H-containing atmosphere. The resulting film may contain fewer impurities and therefore may have improved performance characteristics. The annealing step may be performed in the same reaction chamber in which the deposition process is performed. Alternatively, the substrate may be removed from the reaction chamber, with the annealing/flash annealing process being performed in a separate apparatus. Any of the above post-treatment methods, but especially thermal annealing, has been found effective to reduce carbon and nitrogen contamination of the cobalt-containing film.

### Examples

### Example 1: Synthesis of Co[N(SiMe₃)₂]₂(THF)

A flask was filled with CoCl₂ (7.08g) and THF (50ml). NaN(SiMe₃)₂ THF solution (100mL) was added dropwise at -78°C and then the mixture warmed to room temperature (approximately 23°C, RT). After overnight reaction at room temperature, the solution was filtered through Celite^{™} brand diatomaceous earth and all solvent was removed under vacuum. The light green compound was purified by sublimation under vacuum (50mTorr, 70~80°C). Yield 58%. For XRD analysis, the product was recrystallized from hexane at -30°C. An air sensitive bright green crystal was obtained.

¹H NMR (δ, C₆D₆) -16.98 (s) 96.91 (brs), DSC 58°C (melting point), 183°C (decomposition), vapor pressure 1 Torr at 108°C.

### Example 2: Synthesis of Co[N(SiMe₂Et)₂]₂(THF)

A flask was filled with CoCl₂ and THF. NaN(SiMe₂Et)₂ THF solution was added dropwise at -78°C and then the mixture warmed to room temperature (approximately 23°C, RT). A deep green liquid was obtained.

¹H NMR (δ, C₆D₆) -34.69 (s), -19.67 (s) 2.11 (brs) 89.12 (brs), DSC 215°C (decomposition), vapor pressure 1Torr at 100°C.

### Example 3: Synthesis of Co[N(SiMe₃)₂]₂(adduct)

10 equiv. of an adduct ligand (dried pyridine (py.), dimethylethylamine, diethylmethylamine, triethylamine, 1-methyl-pyrrolidine) were dropped into a hexane solution (5mL) of Co[N(SiMe₃)₂]₂(THF) (1.0g), prepared similar to that of Example 1, under nitrogen. After overnight reaction, solvent and excess adduct ligand was removed under vacuum. Crude product was extracted with dry hexane and filtered through a PTFE filter. The targeted compounds were purified by recrystallization from dry hexane at -30°C and dried under vacuum at room temperature. Each adducted compound was isolated as a blue-green solid. The pyridine adduct (light blue, y.78%), Dimethylethylamine adduct (blue, y.87%), Diethylmethylamine adduct (Deep green, y.56%), Triethylamine adduct (Deep green, y.93%), 1-methyl-pyrrolidine adduct (light blue,y.86%).

Characterization of adducted compounds: Each compound was analyzed by ¹H NMR and XRD.

Py adduct: ¹H NMR (δ, C₆D₆) -18.84 (s) 67.04 (brs), 138.66 (brs), DSC 100°C (m.p.), 216°C(dec), vapor pressure 1Torr at 153°C.

Dimethylethyl amine adduct ¹H NMR (δ, C₆D₆) -24.91 (s) 71.77 (brs), DSC 88°C (m.p.), 203°C(dec), vapor pressure 1Torr at 88°C.

Diethylmethyl amine adduct ¹H NMR (δ, C₆D₆) -22.58 (brs), 59.40 (brs), 97.71 (brs) DSC 90°C (m.p.), 210°C(dec), vapor pressure 1Torr at 82°C.

Triethyl amine adduct ¹H NMR (δ, C₆D₆) -17.01 (s), 96.68 (brs), DSC 221°C(dec), vapor pressure 1Torr at 100°C.

1-Methyl-pyrrolidine adduct ¹H NMR (δ, C₆D₆) -25.07 (s), 62.06 (brs), 76.22 (brs), DSC 148°C (m.p.), 210°C(dec), vapor pressure 1Torr at 114°C.

### Example 4: Synthesis of Co[N(SiMe₂Et)₂]₂(dimethylethylamine)

10 equiv. of dimethylethylamine was added dropwise to a hexane solution (5mL) of Co[N(SiMe₂Et)₂]₂(THF) (1.0g), prepared similar to that as in Example 2, under nitrogen. After overnight reaction, solvent and excess adduct ligand was removed under vacuum. Crude product was extracted with dry hexane and filtered through a PTFE filter. The targeted compounds were purified by distillation under vacuum (30mTorr). Deep green liquid was obtained (y.45%). ¹H NMR (δ, C₆D₆) - 20.45 (brs), -16.20 (s), 0.07 (s) 0.50 (q, J = 8Hz), 0.96 (t, J = 8 Hz), 12.75 (brs) 94.02 (brs). DSC 124°C (dec), vapor pressure of 1Torr at 124°C.

### Example 5: Thermal analysis

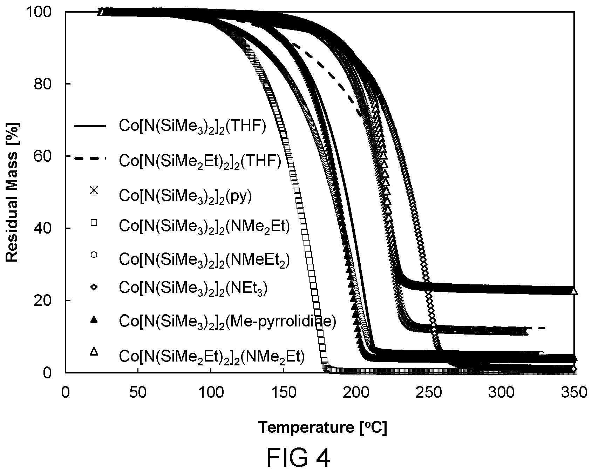

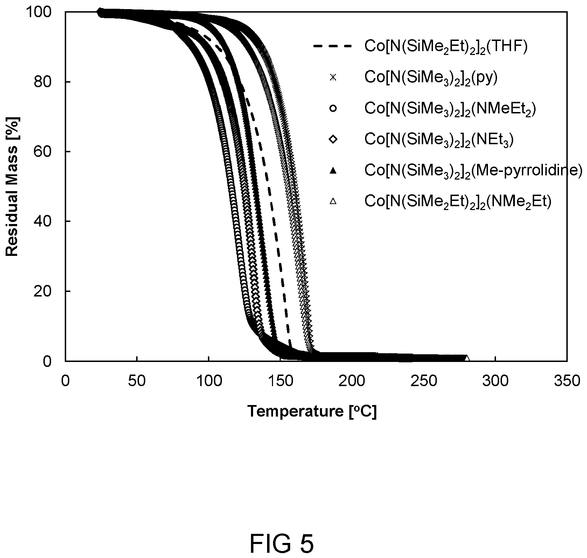

Volatility was monitored by TGA (ThermoGravimetric Analysis, METTLER, TGA/SDTA851) under nitrogen (220sccm). Temperature was increased by 10°C/min. Test sample was prepared under nitrogen in Aluminum pan. The results are shown in **FIGS 4** **and** **5****.**

**FIG 4** is a comparative open cup TGA graph of the Co[N(SiR¹R²R³)₂]₂(adduct) precursors with measurement under 1010 mbar. 1010 mbar is equivalent to atmospheric pressure or the pressure close to or at which the precursor may be stored.

As can be seen in **FIG 4****,** Co[N(SiMe₃)₂]₂(NMe₂Et) exhibits close to 100% evaporation, with Co[N(SiMe₃)₂]₂(NEt₃) also leaving little residue. Co[N(SiMe₃)₂]₂(Me-pyrrolidine), Co[N(SiMe₃)₂]₂(NMeEt₂), and Co[N(SiMe₃)₂]₂(THF) all leave approximately 5-10% residue. Co[N(SiMe₂Et)₂]₂(THF) and Co[N(SiMe₃)₂]₂(py) both leave approximately 10% residue. Co[N(SiMe₂Et)₂]₂(NMe₂Et) leave over 20% residue.

**FIG 5** is a comparative open cup TGA graph of the Co[N(SiR¹R²R³)₂]₂(adduct) precursors with measurement under 20 mbar. 20 mbar represents the pressure close to or at which the precursor may be used.

As can be seen in **FIG 5****,** all of the 6 precursors tested leave close to 0% residue (i.e., Co[N(SiMe₂Et)₂]₂(THF), Co[N(SiMe₃)₂]₂(py), Co[N(SiMe₃)₂]₂(NMeEt₂), Co[N(SiMe₃)₂]₂(NEt₃), Co[N(SiMe₃)₂]₂(Me-pyrrolidine), and Co[N(SiMe₂Et)₂]₂(NMe₂Et).

As demonstrated in **FIGS 4** **and** **5****,** the Co[N(SiR¹R²R³)₂]₂(adduct) precursor family does not exhibit similar properties, notwithstanding the structural similarity of the precursors.

As for selection of precursor, volatility is important to be delivered to the reaction chamber. TGA data under atmospheric pressure tells which precursor is acceptable for use or not. Preferably, the precursor shows clear evaporation under vacuum.

### Example 6: Thermal stress test

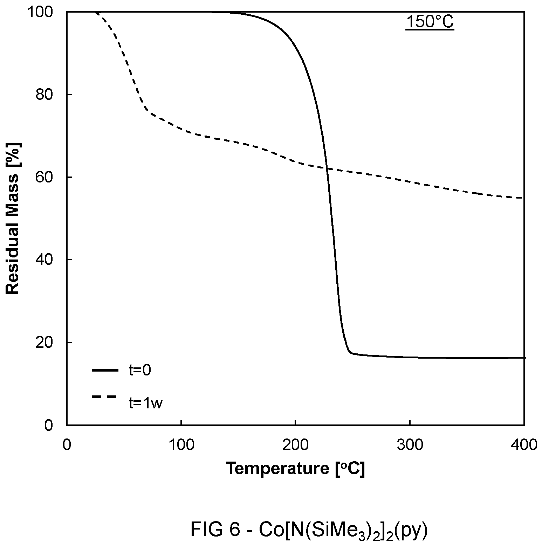

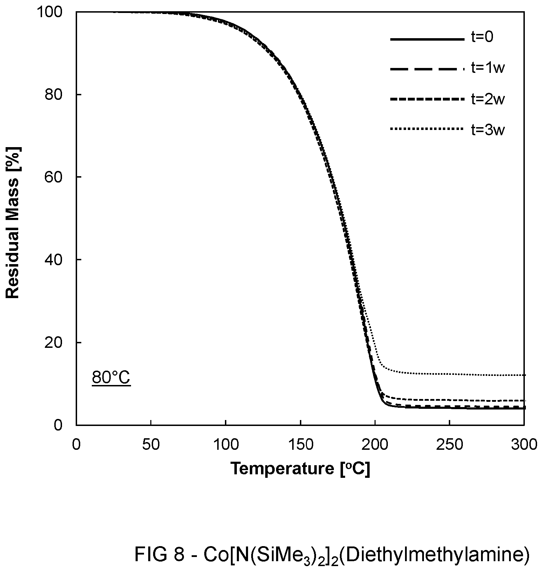

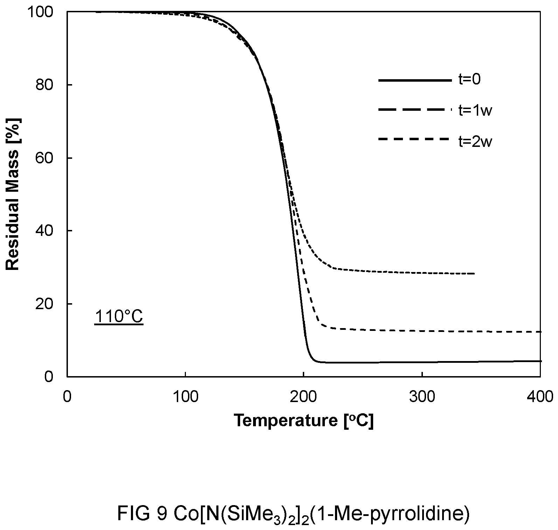

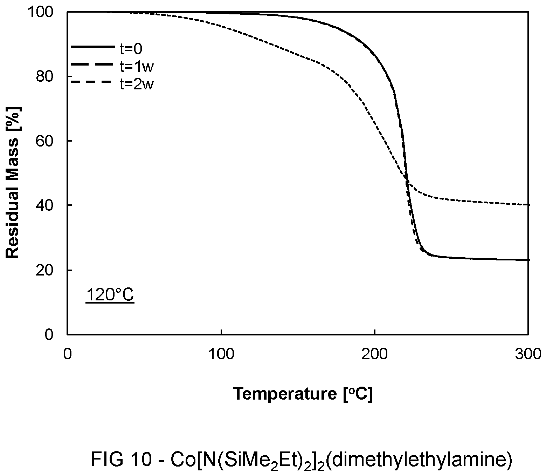

The samples were heated at temperatures which correspond to 1 Torr vapor pressure for 2 weeks ∼3 months. TGA graphs performed at 1010 mbar (atmospheric pressure) showing any changes over the specified periods of time to those samples that had been maintained at the specified temperatures are shown in **FIGS 6-10****.** **FIG 6** shows the results for Co[N(SiMe₃)₂]₂(py) at 150C at 0 and 1 week. **FIG 7** shows the results for Co[N(SiMe₃)₂]₂(NMe₂Et) at 90C at 0; 1, 2 and 3 weeks; and 1 and 2 months. **FIG 8** shows the results for Co[N(SiMe₃)₂]₂(NEt₂Me) at 80C at 0 and 1, 2 and 3 weeks. **FIG 9** shows the results for Co[N(SiMe₃)₂]₂(1-Me-pyrrolidine) at 110C at 0 and 1 and 2 weeks. **FIG 10** shows the results for Co[N(SiMe₂Et)₂]₂(NMe₂Et) at 120C at 0 and 1 and 2 weeks.

The stability of the precursor at usage temperature is also important. When a precursor is used, a canister is heated to give enough vapor, at least 1 Torr. To make high growth rate, the canister may be heated more than 1 Torr temperature. Hence a precursor must be stable without decomposition to keep sending expected vapor.

Materials that are utilized in the semiconductor industry with a low vapor pressure, such as these compounds, must remain stable at elevated temperatures. The elevated temperatures have been selected to provide 1 Torr (133 Pa) vapor/partial pressure of the precursor in a canister as this pressure has been found to be adequate to provide an adequate dosage of material through the distribution system and into the process chamber. The canister may be kept at the elevated temperature for an extended duration that corresponds to the usage rate/productivity of the process tools (e.g., several weeks or several months). Materials that do not maintain their characteristics at such elevated temperatures may not be effectively utilized as precursors for semiconductor processing without additional exceptional equipment or conditioning. Applicants have surprisingly found that the NEtMe₂ adduct of the Co(TMSA)₂ precursor has excellent thermal properties after extended high temperature exposure.

The material stability is not only dependent upon the volatility of the adduct. The NEtMe₂ adduct has a higher volatility than the NEt₂Me adduct (see **FIG 4**), but exhibits significant degradation after three weeks. Additionally, as the precursor contains no oxygen, it may be useful in the deposition of pure Co films.

Applicants believe that the stability of NEtMe₂ will permit conformal step coverage inside holes and trenches with aspect ratios ranging from 3:1 to 50:1, preferably 5:1 to 10:1, because the precursor will not exhibit the degradation of the analogous precursors. Applicants also believe that the NEtMe₂ precursors will provide consistent deposition of face-centered cubic cobalt nitride (Co4N). Co4N provides a strong adhesion-enhancing layer between the TaN or WN and copper seed layers in the copper damascene structure.

It will be understood that many additional changes in the details, materials, steps, and arrangement of parts, which have been herein described and illustrated in order to explain the nature of the invention, may be made by those skilled in the art within the principle and scope of the invention as expressed in the appended claims.

## Claims

1. A method of depositing a Co-containing layer on a substrate, the method comprising introducing a vapor of a Co-containing film forming composition comprising a silylamide-containing precursor into a reactor having a substrate disposed therein, and depositing at least part of the silylamide-containing precursor onto the substrate to form the Co-containing layer using a vapor deposition method, **characterized in that** the Co-containing film forming composition comprises between 95% w/w and 100% w/w of the silylamide-containing precursor, which is selected from Co[N(SiMe₃)₂]₂(NMe₂Et), Co[N(SiMe₃)₂]₂(NMeEt₂), or combinations thereof.

2. The method of claim 1, wherein the silylamide-containing precursor is Co[N(SiMe₃)₂]₂(NMe₂Et).

3. The method of claim 1, wherein the silylamide-containing precursor is Co[N(SiMe₃)₂]₂(NMeEt₂).

4. The method of any one of claims 1 to 3, wherein the Co-containing layer is Co.

5. The method of any one of claims 1 to 3, wherein the Co-containing layer is CoSi₂.

6. The method of claim 4 or 5, wherein the substrate is SiO₂.

7. The method of claim 5, wherein the substrate is Si.

8. The method of claim 1,
- whereby a Co-containing film forming composition delivery device comprising the Co-containing film forming composition is fluidly connected to a vapor deposition chamber as the reactor,;
- whereby the Co-containing film forming composition delivery device is heated to a temperature that generates between approximately 0.2 Torr (approximately 27 Pascal) and approximately 1.5 Torr (approximately 200 Pascal) of vapor pressure of the Co-containing film forming composition;
- whereby the vapor of the Co-containing film forming composition is delivered into the vapor deposition chamber; and
- wherein at least part of the silylamide-containing precursor is deposited onto the substrate to form the Co-containing layer using a vapor deposition method.

9. The method of claim 8, further comprising maintaining the Co-containing film forming composition delivery device at the temperature for a time ranging from 2 weeks to 12 months.

10. The method of claim 8 or 9, wherein the silylamide-containing precursor is Co[N(SiMe₃)₂]₂(NMe₂Et).

11. A cobalt-containing film forming composition comprising a silylamide-containing precursor, **characterized in that** it comprises between 95% w/w and 100% w/w of the silylamide-containing precursor, which is selected from Co[N(SiMe₃)₂]₂(NMe₂Et), Co[N(SiMe₃)₂]₂(NMeEt₂), or combinations thereof, and having a thermal stability demonstrated by thermogravimetric analysis of less than 5% residual mass after 2 weeks at 80°C.

12. The cobalt-containing film forming composition of claim 11, wherein the silylamide-containing precursor is Co[N(SiMe₃)₂]₂(NMe₂Et) and has a thermal stability demonstrated by thermogravimetric analysis of less than 5% residual mass after 2 months at 90°C.

13. The cobalt-containing film forming composition of claim 11, wherein the Co-containing film forming composition consists essentially of a silylamide-containing precursor selected from Co[N(SiMe₃)₂]₂(NMe₂Et), Co[N(SiMe₃)₂]₂(NMeEt₂), or combinations thereof.

14. The cobalt-containing film forming composition of claim 11, wherein the Co-containing film forming composition consists essentially of Co[N(SiMe₃)₂]₂(NMe₂Et).

## Patentansprüche

1. Verfahren zur Abscheidung einer Co-haltigen Schicht auf einem Substrat, wobei das Verfahren das Eintragen eines Dampfs einer Co-haltigen filmbildenden Zusammensetzung, die eine Silylamid-haltige Vorstufe umfasst, in einen Reaktor mit einem darin angeordneten Substrat und das Abscheiden von mindestens einem Teil der Silylamid-haltigen Vorstufe auf dem Substrat unter Bildung der Co-haltigen Schicht unter Verwendung eines Dampfabscheidungsverfahrens umfasst, **dadurch gekennzeichnet, dass** die Co-haltige filmbildende Zusammensetzung zwischen 95 Gew.-% und 100 Gew.-% der Silylamid-haltigen Vorstufe, die aus Co[N(SiMe₃)₂]₂(NMe₂Et), Co[N(SiMe₃)₂]₂(NMeEt₂) oder Kombinationen davon ausgewählt ist, umfasst.

2. Verfahren nach Anspruch 1, wobei es sich bei der Silylamid-haltigen Vorstufe um Co[N(SiMe₃)₂]₂(NMe₂Et) handelt.

3. Verfahren nach Anspruch 1, wobei es sich bei der Silylamid-haltigen Vorstufe um Co[N(SiMe₃)₂]₂(NMeEt₂) handelt.

4. Verfahren nach einem der Ansprüche 1 bis 3, wobei es sich bei der Co-haltigen Schicht um Co handelt.

5. Verfahren nach einem der Ansprüche 1 bis 3, wobei es sich bei der Co-haltigen Schicht um CoSi₂ handelt.

6. Verfahren nach Anspruch 4 oder 5, wobei es sich bei dem Substrat um SiO₂ handelt.

7. Verfahren nach Anspruch 5, wobei es sich bei dem Substrat um Si handelt.

8. Verfahren nach Anspruch 1,
- wobei eine Vorrichtung zur Zuführung der Co-haltigen filmbildenden Zusammensetzung, die die Co-haltige filmbildende Zusammensetzung umfasst, fluidisch mit einer Dampfabscheidungskammer als Reaktor verbunden ist;
- wobei die Vorrichtung zur Zuführung der Co-haltigen filmbildenden Zusammensetzung auf eine Temperatur erhitzt wird, die einen Dampfdruck der Co-haltigen filmbildenden Zusammensetzung zwischen ungefähr 0,2 Torr (ungefähr 27 Pascal) und ungefähr 1,5 Torr (ungefähr 200 Pascal) erzeugt;
- wobei der Dampf der Co-haltigen filmbildenden Zusammensetzung der Dampfabscheidungskammer zugeführt wird und
- wobei mindestens ein Teil der Silylamid-haltigen Vorstufe auf dem Substrat unter Bildung der Co-haltigen Schicht unter Verwendung eines Dampfabscheidungsverfahrens abgeschieden wird.

9. Verfahren nach Anspruch 8, ferner umfassend das Halten der Vorrichtung zur Zuführung der Co-haltigen filmbildenden Zusammensetzung bei der Temperatur über einen Zeitraum im Bereich von 2 Wochen bis 12 Monaten.

10. Verfahren nach Anspruch 8 oder 9, wobei es sich bei der Silylamid-haltigen Vorstufe um Co[N(SiMe₃)₂]₂(NMe₂Et) handelt.

11. Cobalthaltige filmbildende Zusammensetzung, die eine Silylamid-haltige Vorstufe umfasst, **dadurch gekennzeichnet, dass** sie zwischen 95 Gew.-% und 100 Gew.-% der Silylamid-haltigen Vorstufe, die aus Co[N(SiMe₃)₂]₂(NMe₂Et), Co[N(SiMe₃)₂]₂(NMeEt₂) oder Kombinationen davon ausgewählt ist, umfasst und eine durch thermographische Analyse demonstrierte thermische Stabilität von weniger als 5 % Restmasse nach 2 Wochen bei 80 °C aufweist.

12. Cobalthaltige filmbildende Zusammensetzung nach Anspruch 11, wobei die Silylamid-haltige Vorstufe Co[N(SiMe₃)₂]₂(NMe₂Et) ist und eine durch thermogravimetrische Analyse demonstrierte thermische Stabilität von weniger als 5 % Restmasse nach 2 Monaten bei 90 °C aufweist.

13. Cobalthaltige filmbildende Zusammensetzung nach Anspruch 11, wobei die Co-haltige filmbildende Zusammensetzung im Wesentlichen aus einer Silylamid-haltigen Vorstufe, die aus Co[N(SiMe₃)₂]₂(NMe₂Et), Co[N(SiMe₃)₂]₂(NMeEt₂) oder Kombinationen davon ausgewählt ist, besteht.

14. Cobalthaltige filmbildende Zusammensetzung nach Anspruch 11, wobei die Co-haltige filmbildende Zusammensetzung im Wesentlichen aus Co[N(SiMe₃)₂]₂(NMe₂Et) besteht.

## Revendications

1. Procédé de dépôt d'une couche contenant du Co sur un substrat, le procédé comprenant l'introduction d'une vapeur d'une composition filmogène contenant du Co comprenant un précurseur contenant silylamide dans un réacteur ayant un substrat disposé dans celui-ci, et le dépôt d'au moins une partie du précurseur contenant silylamide sur le substrat pour former la couche contenant du Co en utilisant un procédé de dépôt en phase vapeur, **caractérisé en ce que** la composition filmogène contenant du Co comprend entre 95 % p/p et 100 % p/p du précurseur contenant silylamide, qui est choisi parmi Co[N(SiMe₃)₂]₂(NMe₂Et), Co[N(SiMe₃)₂]₂(NMeEt₂), ou des combinaisons correspondantes.

2. Procédé selon la revendication 1, le précurseur contenant silylamide étant Co[N(SiMe₃)₂]₂(NMe₂Et).

3. Procédé selon la revendication 1, le précurseur contenant silylamide étant Co[N(SiMe₃)₂]₂(NMeEt₂).

4. Procédé selon l'une quelconque des revendications 1 à 3, la couche contenant du Co étant Co.

5. Procédé selon l'une quelconque des revendications 1 à 3, la couche contenant du Co étant CoSi₂.

6. Procédé selon la revendication 4 ou 5, le substrat étant SiO₂.

7. Procédé selon la revendication 5, le substrat étant Si.

8. Procédé selon la revendication 1,
- un dispositif d'apport de composition filmogène contenant du Co comprenant la composition filmogène contenant du Co étant connecté de manière fluidique à un compartiment de dépôt en phase vapeur comme le réacteur ;
- le dispositif d'apport de composition filmogène contenant du Co étant chauffé jusqu'à une température qui génère entre approximativement 0,2 Torr (approximativement 27 Pascals) et approximativement 1,5 Torr (approximativement 200 Pascals) de pression de vapeur de la composition filmogène contenant du Co ;
- la vapeur de la composition filmogène contenant du Co étant apportée dans le compartiment de dépôt en phase vapeur ; et
- au moins une partie du précurseur contenant silylamide étant déposée sur le substrat pour former la couche contenant du Co en utilisant un procédé de dépôt en phase vapeur.

9. Procédé selon la revendication 8, comprenant en outre le maintien du dispositif d'apport de composition filmogène contenant du Co à la température pendant une durée dans la plage de 2 semaines à 12 mois.

10. Procédé selon la revendication 8 ou 9, le précurseur contenant silylamide étant Co[N(SiMe₃)₂]₂(NMe₂Et).

11. Composition filmogène contenant du cobalt comprenant un précurseur contenant silylamide, **caractérisée en ce qu'**elle comprend entre 95 % p/p et 100 % p/p du précurseur contenant silylamide, qui est choisi parmi Co[N(SiMe₃)₂]₂(NMe₂Et), Co[N(SiMe₃)₂]₂(NMeEt₂), ou des combinaisons correspondantes, et ayant une stabilité thermique démontrée par analyse thermogravimétrique de moins de 5 % de masse résiduelle après 2 semaines à 80 °C.

12. Composition filmogène contenant du cobalt selon la revendication 11, le précurseur contenant silylamide étant Co[N(SiMe₃)₂]₂(NMe₂Et) et ayant une stabilité thermique démontrée par analyse thermogravimétrique de moins de 5 % de masse résiduelle après 2 mois à 90 °C.

13. Composition filmogène contenant du cobalt selon la revendication 11, la composition filmogène contenant du Co étant essentiellement constituée d'un précurseur contenant silylamide choisi parmi Co[N(SiMe₃)₂]₂(NMe₂Et), Co[N(SiMe₃)₂]₂(NMeEt₂), ou des combinaisons correspondantes.

14. Composition filmogène contenant du cobalt selon la revendication 11, la composition filmogène contenant du Co étant essentiellement constituée de Co[N(SiMe₃)₂]₂(NMe₂Et).
